# EUROPEAN PATENT SPECIFICATION

(11) **EP 0 562 819 B1**
(45) Date of publication and mention of the grant of the patent: **01.12.1999**
(21) Application number: 93302193.3
(22) Date of filing: 23.03.1993
(51) Int. Cl.: G03F 7/004, G03F 7/039

(54) **Resist coating composition**
Schutzlack-Überzugszusammensetzung
Composition de revêtement formant réserve

(30) Priority: 23.03.1992 JP 9495692
(43) Date of publication of application: 29.09.1993
(73) Proprietor: JSR Corporation, Tokyo 104 (JP)
(72) Inventor: Murata, Makoto, Tokkaichi-shi, Mie-ken (JP); Ota, Toshiyuki, Yokkaichi-shi, Mie-ken (JP); Yumoto, Yoshiji, Yokkaichi-shi, Mie-ken (JP); Miura, Takao, Yokkaichi-shi, Mie-ken (JP)
(74) Representative: Clifford, Frederick Alan

(56) References cited:
- EP-A- 0 166 682
- EP-A- 0 211 667
- EP-A- 0 273 026
- EP-A- 0 330 386
- EP-A- 0 336 605
- EP-A- 0 388 813
- EP-A- 0 419 147
- EP-A- 0 440 374
- EP-A- 0 506 593
- DE-A- 4 124 426
- DE-A- 4 229 816
- SOLID STATE TECHNOLOGY vol. 34, no. 9, August 1991, WASHINGTON US pages 53 - 60 A.A:. LAMOLA ET AL. 'Chemically Amplified Resists'
- PATENT ABSTRACTS OF JAPAN vol. 015, no. 305 (P-1234)5 August 1991
- JOURNAL OF VACUUM SCIENCE AND TECHNOLOGY: PART B vol. 9, no. 6, Nov./Dec. 1991, NEW YORK US pages 3343 - 3347 H.SHIRAISHI ET AL. 'Novolak resin-based positive electron-beam resist system utilizing acid-sensitive polymeric dissolultion inhibitor with solubility reactivity'
- PATENT ABSTRACTS OF JAPAN vol. 13, no. 403 (P-929)(3751) 7 September 1989

## Description

### Detailed Description of the Invention

The present invention relates to a resist coating composition. More specifically, it relates to a resist coating composition suitable for ultrafine processing by means of radiation such as i-ray or far ultraviolet light.

In the field of fine processing typified by the production of integrated circuits, the processing size in lithography is becoming finer, and in recent years, there is required a technology by which a fine processing for a breadth of 0.5 µm or less can be stably performed. Therefore, a resist used for this purpose is required to form a pattern having a line breadth of 0.5 µm or less with good accuracy. Therefore, studies on lithography using radiation having a shorter wavelength (300 nm or less) are under way.

The above radiation includes ultraviolet light typified by i-ray (365 nm), far ultraviolet light typified by KrF excimer laser (248 nm), X-ray typified by synchrotron radiation and charged corpuscular beam typified by electron beam. A variety of resists for use with these radiations have been proposed recent years.

Among these resists, attention is particularly being brought to resists which undergo a reaction to change their solubility in a developer solution by the catalytic activity of an acid formed when exposed to radiation. These resists are generally called "chemically amplified resists".

When a resist is actually used in a process for producing integrated circuits, generally, a resist solution (to be referred to as "resist coating composition" hereinafter) is prepared by dissolving resist components such as a radiation-sensitive component, a coating-forming component, etc., in a solvent, and spin-coated or roll-coated on a substrate to be processed, thereby to form a resist coating. Therefore, the performances of the resist coating composition such as coatability and storage stability are essential for stably carrying out highly fine processing. Further, the resist coating forms a pattern suitable for fine processing when exposed to radiation, and the form of the pattern has a crucial influence on the accuracy of fine processing. Generally, a rectangular solid form is considered to be desirable.

European Patent Publication No.0 211 667A2 discloses a radiation-sensitive resin composition comprising a solution of an alkali-soluble resin and a radiation-sensitive compound in a solvent which comprises a monooxymonocarboxylic acid ester.

The above European Patent Publication describes that when the above composition is positive, 1,2-quinonediazide compound is used as the radiation-sensitive compound, and that when it is negative, an azide compound is used as the radiation-sensitive compound. The above European Patent Publication also discloses 3-methoxypropionic acid methyl ester as the monooxymonocarboxylic acid ester.

Japanese Laid-open Patent Publication No. 98,652/1988 discloses a positive radiation-sensitive composition containing (A) an alkali-soluble resin, (B) at least one member selected from polyolefinsulfone and halogenated polyolefin sulfone and (C) a solvent containing monooxymonocarboxylic acid ester. This composition is not a chemically amplified composition. This Japanese Laid-open Patent Publication discloses methyl 3-methoxypropionate as the monooxymonocarboxylic acid ester (C).

Japanese Laid-open Patent Publication No. 107,161/1991 discloses a resist composition containing (A) an alkali-soluble phenolic resin and (B) a 1,2-naphthoquinonediazide-4-sulfonic acid ester of a compound having a phenolic hydroxyl group as a sensitizer. This Japanese Laid-open Patent Publication also discloses that the above resist composition may additionally contain (C) a compound which is acid-cleavable under irradiation of actinic radiation, such as an onium salt, a halogenated organic compound and a halogenated organic compound/organic metal mixture. Further, this Japanese Laid-open Patent Publication describes that the solvent used for applying the above resist composition to a substrate is selected from methyl 2-oxypropionate, ethyl 2-oxypropionate, methyl 2-methoxypropionate and ethyl 2-methoxypropionate.

Japanese Laid-open Patent Publication No. 107,160/1991 discloses a resist composition containing (A) an alkali-soluble hydrogenated phenolic resin, (B) a compound which can be acid-cleavable under irradiation with actinic radiation and (C) a dissolution inhibitor having an acid-decomposable group.

The above Japanese Laid-open Patent Publication discloses that the above compound (B) and the solvent can be selected from the same compounds as those described in the previous Japanese Laid-open Patent Publication No. 107,161/1991. Further, it is disclosed that specific examples of the dissolution inhibitor include compounds having an Si-O-C bond, compounds having an Si-N bond and compounds having a C-S-C bond.

The above Japanese Laid-open Patent Publication No. 101, 160/1991 describes, as mentioned above, that the invention intends to provide a resist composition well-balanced among sensitivity, resolution, etching resistance and storage stability by using not a phenolic resin but a hydrogenated phenolic resin.

Japanese Laid-open Patent Publication No. 107,165/1991 discloses a resist composition containing a copolymer having structural units of the formulae (a) and (b) in the molecular chain, 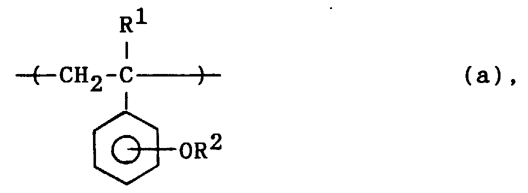 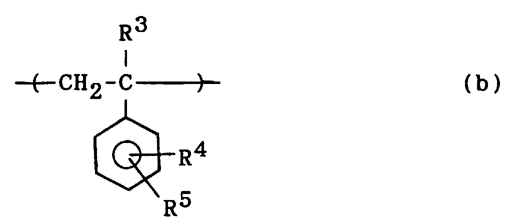 wherein each of R¹ and R³ is H or an alkyl group, R² is an alkyl group, -SO₂R⁶ or -CO₂R⁶, in which R⁶ is an alkyl group or an aryl group, and each of R⁴ and R⁵ is H, a halogen atom or an alkyl group,
and a compound acid-cleavable under irradiation with actinic radiation.

The above resist composition has a characteristic feature in the use of the above copolymer which is sparingly soluble in an alkali and is modified to become soluble in an alkali when exposed to light.

Japanese Laid-open Patent Publication No. 107,163/1991 a resist composition containing an alkali-soluble phenolic resin, a compound which is acid-cleavable under irradiation with actinic radiation and spiro-orthocarbonate.

The characteristic feature of the above resist composition is that it contains the above spiro-orthocarbonate which has the property of inhibiting the dissolution of the alkali-soluble phenolic resin in a developer solution and the property of promoting the dissolution of the alkali-soluble resin in the developer solution in the presence of an acid derived from an agent which generates an acid with irradiation of light.

European Patent Publication No. 0 419 147A2 discloses a resist composition comprising:
(A) a hydrogenated alkali-soluble phenolic resin,
(B) a compound capable of generating an acid on irradiation; and
(C) a compound capable of crosslinking in the presence of the acid.

The above European Patent Publication describes that the above compound (B) and the solvent are selected from those described in the previous Japanese Laid-open Patent Publication No. 107,161/1991. It is also described that the above compound (C) includes compounds having a group of -C-O-alkyl and compounds having an epoxy group.

Japanese Laid-open Patent Publication No. 107,164/1991 discloses a resist composition containing (A) a photosensitive resin prepared by modifying an alkali-soluble phenolic resin with a photosensitive compound and (B) a compound which is acid-cleavable under irradiation with actinic radiation. It discloses that the photosensitive compound to modify the alkalisoluble phenolic resin includes diazidesulfonic acid ester, a diazocarbonyl compound and an o-nitrobenzyl compound. It is described that the above compound (B) and the solvent are selected from those described in the previous Japanese Laid-open Patent Publication No. 107,161/1991.

Japanese Laid-open Patent Publication No. 328,747/1992 discloses a photoresist composition comprising a polymer resin, a photosensitive compound and an ethyl-3-ethoxypropionate solvent. Example 3 of this Japanese Laid-open Patent Publication describes that a preparation of trifluorosulfonyloxybicyclo[2.2.1]hept-5-ene-2,3-dicarboxyimide (MDT) in a polyhydroxystyrene-poly-t-butoxycarbonyloxystyrene copolymer was treated with propylene glycol methyl ether acetate and ethyl 3-ethoxypropionate, and the coating formed by spin-casting was measured for its film uniformity of the silicon wafer.

U.S. Patent 4,965,167 discloses a light-sensitive composition useful as a positive-working photoresist, comprising an admixture of:
(a) at least one alkali-soluble binder resin, preferably a phenolic novolak resin;
(b) at least one photoactive compound, preferably a photoactive o-quinonediazide compound, and
(c) a sufficient amount of a solvent mixture comprising ethylacetate and 3-ethoxy propionate to dissolve (a) and (b).

U.S. Patent 4,943,511 discloses a positive photosensitive composition containing a solvent which is selected from the group consisting of (1) a mixture of ethyl Cellosolve acetate, butyl acetate and xylene; (2) a mixture of propylene glycol monomethyl ether acetate, butyl acetate and xylene; (3) ethyl-3-ethoxy propionate; (4) propylene glycol monomethyl ether acetate; and (5) a mixture of propylene glycol monomethyl ether acetate, butyl acetate and ethyl 3-ethoxy propionate.

The above positive photosensitive composition contains also a photosensitizer which is a mixture of mono-, di- and tri-esters of 2,3,4-trihydroxybenzophenone and 1,2-naphthoquinone-2-diazo-4-sulfonyl chloride and a novolak resin.

European Patent Publication No. 0 273 026A2 discloses a composition comprising a single-phase liquid mixture of: (a) at least one photoactive component (PAC) consisting of an oxo-diazonaphthalene sulfonate or carboxylate polyester of a polyhydroxy ballast compound; (b) at least one alkali soluble phenolic resin; and (c) a solvent.

It is disclosed that the specific examples of the solvent include methyl-3-methoxypropionate and ethyl-3-methoxypropionate.

Chemically amplified resists are described in an article entitled "Chemically Amplified Resists" from Solid State Technology Volume 34 (1991) August, No.9 Westford, MA, US., Angelo. A. Lamola et al.

DE-A-4124426 discloses a composition comprising a compound which is decomposed by irradiation with radiation to generate an acid, an organic base and an alkali-soluble resin.

EP-A-440374 discloses a composition comprising a resin having a special functional group, a phenolic hydroxyl group and optionally another structural unit, a photo-acid generator and a solvent. The solvent may be methyl 3-methoxypropionate. The specific resin disclosed gives good contrast and resists peeling of the resist material film in development.

EP-A-330386 is not concerned with a chemically amplified resist composition. It discloses a composition comprising a resin containing a specific structural unit having a sulphonyl group in the main chain and an acid generator.

EP-A-388813 discloses a composition comprising a resin or a compound whose solubility in an alkali aqueous solution changes with catalytic activity of an acid and an acid precursor such as an alkylsulhponic acid ester compound.

An article entitled "Novalak resin-based electron-beam resist system utilising acid-sensitive polymeric dissolution inhibitor with solubility reversal reactivity" (Journal Of Vacuum Science & Technology B. Vol. 9(1991) Nov./Dec. No. 6, pages 3343-3347, New York Shiraishi et al) discloses a specific positive type resist composition that reverses solubility, comprising an acid-sensitive polymeric dissolution inhibitor, an acid generator and a novolak resin.

As is disclosed in some of-the above prior art documents. it is known that a resist containing a novolak resin and a naphthoquinonediazide-containing sensitizer, used in conventional lithography using visible light or ultraviolet light, can achieve the above-described performances by using an ethyl cellosolve- or methyl cellosolve-containing compound as a solvent used for the preparation of a resist coating composition. Concerning "chemically amplified resist", a resist coating composition has a problem in storage stability when ethyl 2-hydroxypropionate is used as a solvent for preparing the resist coating composition.

That is, a chemically amplified resist containing ethyl 2-hydroxypropionate as a solvent has a problem in that the sensitivity of the resist and the form of a pattern vary with the passage of time after a resist solution has been prepared.

It is an object of the present invention to provide a novel resist coating composition.

It is another object of the present invention to provide a resist coating composition suitable as a resist composition which permits stable fine processing, has an excellent storage stability and gives an excellent form of a pattern.

It is further another object of the present invention to provide a resist coating composition having an excellent storage stability, which is capable of giving excellent resist sensitivity and an excellent form of a pattern with good reproducibility even after storage of a prepared resist solution for a long period of time.

Other objects and advantages of the present invention will be apparent from the following description.

The present invention provides a negative resist coating composition (to be referred to as the resist coating composition hereinafter) comprising:
(a) 100 parts by weight of an alkali soluble resin (resin A),
(b) 1 to 70 parts by weight of at least one radiation sensitive acid forming agent selected from the group consisting of an onium salt compound, a halogen containing compound, a sulphonate compound, a nitrobenzyl compound and a sulphone compound,
(c') 5 to 95 parts by weight of a compound which cross-links the (a) alkali-soluble resin in the presence of an add (to be referred to as the "cross linking agent" herein after), and
(d) 20 to 3,000 parts by weight of at least one solvent selected from methyl 3-methoxy propionate (MMP) or ethyl 3-methoxypropionate (EEP).

The above resist coating compositions of the present invention will be explained hereinafter. Each component of the resist coating compositions will be explained first.

### Resin (a)

The resin (a) (hereinafter, resin (A)) used in the first and second resist coating compositions is not specially limited if it has the property of being soluble in an alkali developer solution.

Therefore, the resin (A) is only required to be a resin having a functional group having affinity to an alkali developer solution, e.g., an acidic functional group such as a phenolic hydroxyl group or a carboxyl group. As the resin (A), preferred is a polymer having at least one recurring unit selected from the group consisting of a recurring unit of the formula (1), 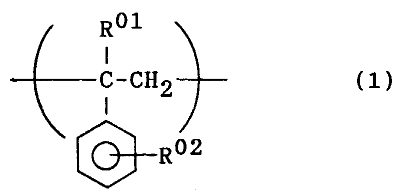 wherein R⁰¹ is hydrogen atom or a methyl group, R⁰² is a hydroxyl group, a carboxyl group, a group of -R⁰³COOH, a group of -OR⁰³COOH or a group of 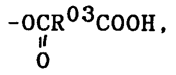 in which R⁰³ is an alkylene group having 1 to 4 carbon atoms,
a recurring unit of the formula (2), 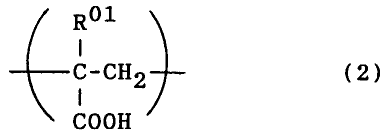 wherein R⁰¹ is as defined in the above formula (1),
a recurring unit of the formula (3), 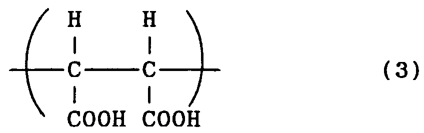 and a recurring unit of the formula (4), 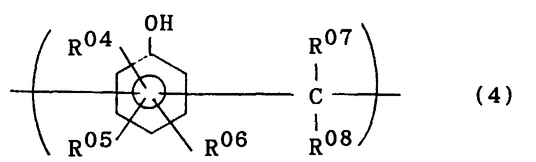 wherein each of R⁰⁴, R⁰⁵, R⁰⁶, R⁰⁷ and R⁰⁸ is independently hydrogen atom or an alkyl group having 1 to 4 carbon atoms.

The resin (A) may be composed of recurring units of any one of the formulae (1), (2), (3) and (4) alone. It may also contain other recurring unit. The "other recurring unit" includes recurring units derived from the cleavage of double bonds of monomers having a double bond such as styrene, methyl styrene, alkyl (meth)acrylate containing an alkyl group having 1 to 4 carbon atoms, maleic anhydride, fumaronitrile, acrylamide, acrylonitrile, vinylpyridine, vinylpyrrolidone, vinylimidazole and vinylaniline when a polymer contains recurring units represented by the formulae (1), (2) or (3).

Although not uniformly determined due to the content of other recurring unit, the content of the recurring units of the formulae (1), (2), (3) and (4) is generally at least 15 mol%, preferably at least 20 mol%.

The molecular weight (to be referred to as "Mw" hereinafter), i.e., weight average molecular weight as a polystyrene measured by gel permeation chromatography (to be referred to as "GPC"), of the resin (A) is preferably 1,000 to 150,000, particularly preferably 3,000 to 100,000.

The resin (A) used in the present invention can be obtained by polymerizing a corresponding vinyl monomer or by polycondensing a phenol or phenol derivative and an aldehyde or an aldehyde derivative.

The resin (A) that contains the recurring unit of the formula (1) or (2) can be also used in the form of a hydrogenation product having a hydrogenation ratio of 70 % or less, preferably 50 % or less, more preferably 40 % or less.

### Radiation-sensitive acid-forming agent

The radiation-sensitive acid-forming agent, i.e., a compound which generates an acid by responding to radiation,used in the present invention, includes an onium salt compound, a halogen-containing compound, a sulfone compound, a sulfonate compound and a nitrobenzyl compound. Specific examples thereof are as follows.

Examples of the onium salt include iodonium salt, sulfonium salt, phosphonium salt, diazonium salt and pyridiniun salt. Preferred is at least one onium salt selected from the group consisting of sulfonium salt of the formula (5), 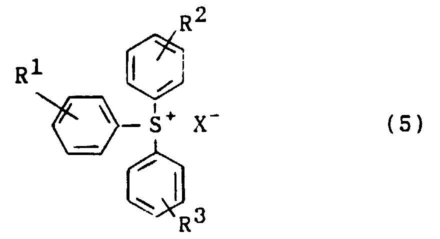 wherein each of R¹, R² and R³ is independently hydrogen atom, a hydroxyl group, an amino group, a nitro group, a cyano group, an alkyl group having 1 to 4 carbon atoms or an alkoxy group having 1 to 4 carbon atoms, and X is SbF₆, AsF₆, PF₆, BF₄, CF₃CO₂, ClO₄, CF₃SO₃, 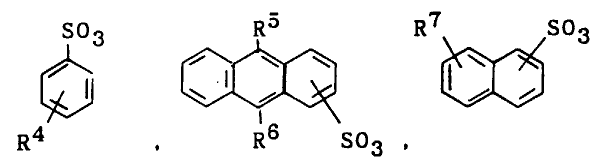 or 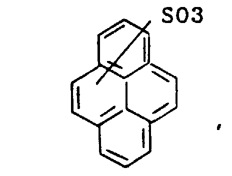 in which R⁴ is hydrogen atom, an amino group, an anilino group, an alkyl group having 1 to 4 carbon atoms or an alkoxy group having 1 to 4 carbon atoms, each of R⁵ and R⁶ is independently an alkoxy group having 1 to 4 carbon atoms and R⁷ is hydrogen atom, an amino group, an anilino group, an alkyl group having 1 to 4 carbon atoms or an alkoxy group
having 1 to 4 carbon atoms,
iodonium salt of the formula (6) 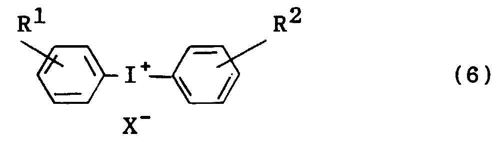 wherein R¹, R² and X are as defined in the above formula (5),
and pyridinium salt of the formula (7) 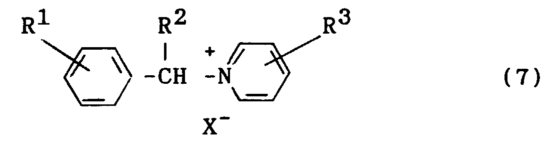 wherein R¹, R², R³ and X are as defined in the above formula (5).

Examples of the halogen-containing compound include a haloalkyl group-containing hydrocarbon compound and a haloalkyl group-containing heterocyclic compound. Preferred is at least one halogen-containing compound selected from the group consisting of a compound of the formula (8), 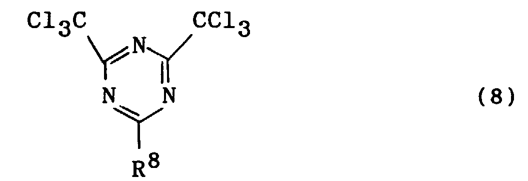 wherein R⁸ is a monovalent organic group such ads trichloromethyl, phenyl, methoxyphenyl, naphthyl, methoxynaphthyl, chlorophenyl, methylenedioxyphenyl and styryl,
and a compound of the formula (9), 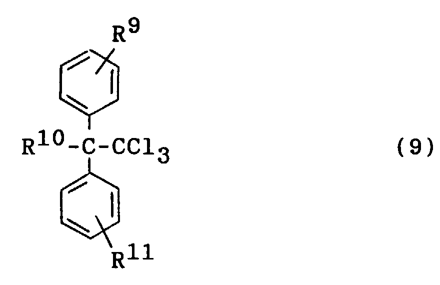 wherein each of R9, R10 and R11 is hydrogen atom, a halogen atom, a methyl group, a methoxy group or a hydroxyl group.

Examples of the sulfone compound include β-ketonesulfone and β-sulfonylsulfone. Preferred is a sulfone compound of the formula (10), 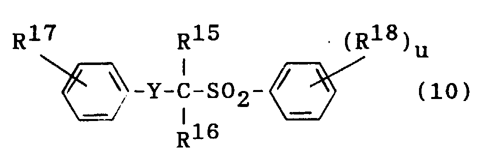 wherein Y is 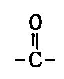 or -SO₂-, each of R¹⁵, R¹⁶, R¹⁷ and R¹⁸ is independently hydrogen atom, an alkyl group having 1 to 4 carbon atoms or a halogen atom, and u is an integer of 0 to 3.

Examples of the nitrobenzyl compound include a nitrobenzylsulfonate compound and a dinitrobenzylsulfonate compound. Preferred is a nitrobenzyl compound of the formula (11), 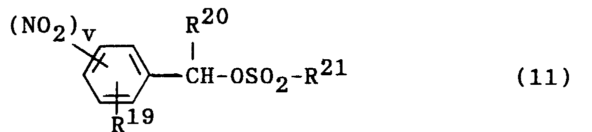 wherein R¹⁹ is an alkyl group having 1 to 4 carbon atoms, R²⁰ is hydrogen atom or a methyl group, R²¹ is or 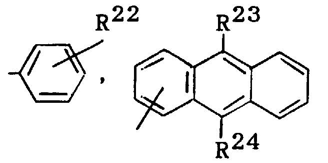 or 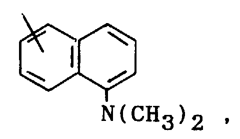 in which R²² is hydrogen atom or a methyl group and each of R²³ and R²⁴ is independently an alkoxy group having 1 to 4 carbon atoms, and v is an integer of 1 to 3. Examples of the sulfonate compound include alkylsulfonic acid ester, haloalkylsulfonic acid ester, arylsulfonic acid ester and iminosulfonate.
Preferred is at least one sulfonate compound selected from the group consisting of a compound of the formula (12), 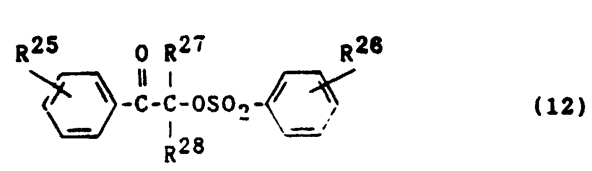 wherein each of R²⁵ and R²⁶ is independently hydrogen atom or an alkyl group having 1 to 4 carbon atoms, each of R²⁷ and R²⁸ is independently hydrogen atom, an alkyl group having 1 to 4 carbon atoms or an aryl group having 6 to 20 carbon atoms,
a compound of the formula (13), 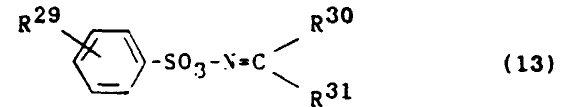 wherein R²⁹ is hydrogen atom or an alkyl group having 1 to 4 carbon atoms, and each of R³⁰ and R³¹ is independently an alkyl group having 1 to 4 carbon atoms or an aryl group having 6 to 20 carbon atoms, or R³⁰ and R³¹ may bond together to form a ring with a carbon atom to which the R³⁰ and R³¹ bond,
and a compound of the formula (14), 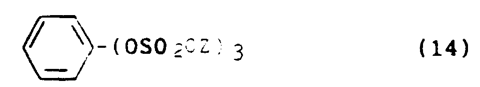 wherein Z is an alkyl group having 1 to 4 carbon atoms, an aryl group having 6 to 20 carbon atoms, trifluoromethyl group or trichloromethyl group.

Among the above compounds, the onium salt is particularly preferred. The amount of the radiation-sensitive acid-forming agent per 100 parts by weight of the above resin (A) is preferably 1 to 70 parts by weight, more preferably 3 to 50 parts by weight, particularly preferably 3 to 20 parts by weight. When this amount is less than 1 part by weight, it is difficult to obtain suffident pattern-formability. When it exceeds 70 parts by weight, scumming is liable to occur.

### Crosslinking agent

The resist coating composition contains a crosslinking agent. This crosslinking agent is a compound which crosslinks the resin (A) in the presence of an acid, e.g., add generated upon exposure to radiation.

The above crosslinking agent is not specially limited if it has the above property. As the crosslinking agent, preferred is, for example, an aromatic compound having a substituent which can undergo a crosslinking reaction.

Examples of the crosslinking agent, i.e., the (c') compound, indude an aromatic compound having a group of the following formula.

-C-(R³⁷R³⁸)-OR³⁹

wherein each of R³⁷ and R³⁸ is independently hydrogen atom or an alkyl group having 1 to 4 carbon atoms and R³⁹ is hydrogen atom or an alkyl group having 1 to 5 carbon atoms, an aralkyl group having 7 to 20 carbon atoms, a group of -NR⁴⁰R⁴¹ in which each of R⁴⁰ and r⁴¹ is independently an alkyl group having 1 to 4 carbon atoms or a cyclo-ring of 3 to 8 atoms containing a hetero-atom or no hetero-atom, or a group of -COR⁴² in which R⁴² is an alkyl group having 1 to 4 carbon atoms or an aryl group having 6 to 14 carbon atoms,
an aromatic compound having a group of the following formula,

-CO-R⁴³

wherein R⁴³ is hydrogen atom or an alkyl group having 1 to 4 carbon atoms,
an aromatic compound having a group of the following formula,

-CR⁴⁴=CR⁴⁵R⁴⁶

wherein each of R⁴⁴, R⁴⁵ and R⁴⁶ is independently hydrogen atom or an alkyl group having 1 to 4 carbon atoms,
and an aromatic compound having a group of the following formula,

-C(R⁴⁷R⁴⁸)R⁴⁹

wherein each of R⁴⁷ and R⁴⁸ is independently hydrogen atom or an alkyl group having 1 to 4 carbon atoms, and R⁴⁹ is a three-membered ring which consists of either an oxygen atom or a divalent sulfur atom and of two carbon and hydrogen atoms and which may have a substituent having 1 to 3 carbon atoms.

Examples of the above group which can undergo a crosslinking reaction include a glycidyl ether group, a glycidyl ester group, glycidylamino group, methoxymethyl group, methylol group, ethoxymethyl group, benzyloxymethyl group, dimethylaminomethyl group, diethoxymethylamino group, morpholinomethyl group, acetoxymethyl group, benzoyloxymethyl group, formyl group, acetyl group, vinyl group and isopropenyl group.

Examples of the aromatic compounds having the above substituents include a bisphenol A epoxy compound, a bisphenol F epoxy compound, a bisphenol S epoxy compound, a novolak epoxy compound, a resol resin epoxy compound, a polyhydroxystyrene epoxy compound, a methylol group-containing melamine resin, a methylol group-containing benzoguanamine resin, a methylol group-containing urea resin, a methylol group-containing phenolic resin, a methylol group-containing melamine compound, a methylol group-containing phenol compound, an alkoxy methyl group-containing melamine resin, an alkoxy methyl group-containing benzoguanamine resin, an alkoxy methyl group-containing urea resin, an alkoxy methyl group-containing phenolic resin, an alkoxy methyl group-containing melamine compound, an alkoxy methyl group-containing phenol compound, a acetoxymethyl group-containing melamine resin, a acetoxymethyl group-containing benzoguanamine resin, a acetoxymethyl group-containing urea resin, a acetoxymethyl group-containing phenolic resin, a acetoxymethyl group-containing melamine compound and a acetoxymethyl group-containing phenol compound.

Of the above aromatic compounds, preferred are a methylol group-containing phenolic resin, a methylol group-containing phenol compound, a methoxymethyl group-containing melamine compound, a methoxymethyl group-containing phenol compound and an acetoxymethyl group-containing phenol compound. More preferred is a methoxymethyl group-containing melamine compound. Specific examples of said compound include CYMEL 300(TM), CYMEL 301(TM), CYMEL 303(TM) and CYMEL305(TM), all supplied by Mitsui Cyanamid Ltd.

Further, as the crosslinking agent, there can be used a modification product of the resin (A), which is a product imparted with the property of a crosslinking agent by modifying the resin (A) with the above substituent which can undergo a crosslinking agent. In this case, the above substituent is introduced in such an amount that the amount of the introduced substituent based on the total amount of the acidic functional group of the resin (A) is generally 5 to 60 %. preferably 10 to 50 %, more preferably 15 to 40 %. When the above amount is less than 5 %, undesirably, it is difficult to achieve a sufficient crosslinking reaction, and as a result, the ratio of the remaining coating declines and the pattern is liable to have a non-uniform line breadth and swell. When it exceeds 60 %, the alkali solubility of the resin (A) tends to decrease to deteriorate developability.

The amount of the crosslinking agent per 100 parts by weight of the resin (A) is preferably 5 to 95 parts by weight, particularly preferably 15 to 85 parts by weight, further particularly preferably 20 to 75 parts by weight. When this amount is less than 5 parts by weight, it is difficult to achieve a sufficient crosslinking reaction. and as a result, the ratio of a remaining coating decreases and the pattern is liable to have a non-uniform line breadth and swell. When it exceeds 95 %, scumming tends to occur to a great extent to deteriorate developability.

### Solvent

The solvent is selected from MMP, EEP or a mixture of these.

The above solvent imparts the resist coating compositions with an excellent storage stability, and can provide the resist coating composition with the property of being capable of giving excellent resist sensitivity and an excellent form of a pattern with good reproducibility even after a prepared resist solution is stored for a long period of time.

The amount of the solvent per 100 parts by weight of the resin (A) is 20 to 3,000 parts by weight. preferably 50 to 3,000 parts by weight, more preferably 100 to 2,000 parts by weight.

In the present invention, other solvent may be added to the solvent of MMP and/or EEP. The amount of the other solvent based on the total solvent amount is, for example, less than 70 % by weight, preferably less than 50 % by weight, particularly preferably 30 % by weight.

The above "other solvent" include a compound of the formula (i),

(R⁵⁰O)ₙR⁵¹COOR⁵² (i)

wherein R⁵⁰ is hydrogen atom or a monovalent hydrocarbon group having 1 to 4 carbon atoms, R⁵¹ is a divalent or trivalent hydrocarbon group having 1 to 4 carbon atoms, R⁵² is a monovalent hydrocarbon group having 1 to 4 carbon atoms and n is 1 or 2, provided that the case where R⁵⁰ and R⁵² are methyl and R⁵¹ is a divalent C₂ hydrocarbon is excluded and that the case where R⁵⁰ and R⁵² are ethyl and R⁵¹ is a divalent C₂ hydrocarbon is excluded.

The monovalent hydrocarbon group having 1 to 4 carbon atoms is preferably selected from an linear or branched alkyl group. The divalent or trivalent hydrocarbon group having 1 to 4 carbon atoms is preferably selected from a divalent or trivalent, linear or branched aliphatic hydrocarbon group.

Specific examples of the above compound include alkyl hydroxyacetates such as methyl hydroxyacetate, methyl methoxyacetate, methyl ethoxyacetate, methyl propoxyacetate, methyl butoxyacetate, ethyl hydroxyacetate, ethyl methoxyacetate, ethyl ethoxyacetate, ethyl propoxyacetate, ethyl butoxyacetate, propyl propoxyacetate and butyl butoxyacetate, and derivatives of these; alkyl 2-hydroxypropionates such as methyl 2-hydroxypropionate, methyl 2-methoxypropionate, methyl 2-ethoxypropionate, methyl 2-propoxypropionate, methyl 2-butoxypropionate, ethyl 2-hydroxypropionate, ethyl 2-methoxypropionate, ethyl 2-ethoxypropionate, ethyl 2-propoxypropionate, ethyl 2-butoxypropionate, propyl 2-propoxypropionate and butyl 2-butoxypropionate, and derivatives of these; alkyl 3-hydroxypropionates such as methyl 3-hydroxypropionate, methyl 3-ethoxypropionate, methyl 3-propoxypropionate, methyl 3-butoxypropionate, ethyl 3-hydroxypropionate, ethyl 3-methoxypropionate, ethyl 3-propoxypropionate, ethyl 3-butoxypropionate, propyl 3-propoxypropionate and butyl 3-butoxypropionate, and derivatives of these; alkyl 3,3-dihydroxypropionates such as methyl 3,3-dihydroxypropionate, methyl 3,3-dimethoxypropionate, methyl 3,3-diethoxypropionate, methyl 3,3-dipropoxypropionate, methyl 3,3-dibutoxypropionate, ethyl 3,3-dihydroxypropionate, ethyl 3,3-dimethoxypropionate, ethyl 3,3-diethoxypropionate, ethyl 3,3-dipropxypropionate and ethyl 3,3-dibutoxypropionate, and derivatives of these; alkyl 4-hydroxybutyrates such as methyl 4-hydroxybutyrate, methyl 4-methoxybutyrate, methyl 4-ethoxybutyrate, methyl 4-propoxybutyrate, ethyl 4-hydroxybutyrate, ethyl 4-methoxybutyrate, ethyl 4-ethoxybutyrate and ethyl 4-propoxybutyrate, and derivatives of these; alkyl 4,4-dihydroxybutyrates such as methyl 4,4-dihydroxybutyrate, methyl 4,4-dimethoxybutyrate, methyl 4,4-diethoxybutyrate, methyl 4,4-dipropoxybutyrate, methyl 4,4-dihydroxybutyrate, ethyl 4,4-dimethoxybutyrate, ethyl 4,4-diethoxybutyrate and ethyl 4,4-dipropoxybutyrate, and derivatives of these; alkyl 5-hydroxyvalerates such as methyl 5-methoxyvalerate, methyl 5-hydroxyvalerate, methyl 5-ethoxyvalerate, methyl 5-propoxyvalerate, ethyl 5-hydroxyvalerate, ethyl 5-methoxyvalerate, ethyl 5-ethoxyvalerate and ethyl 5-propoxyvalerate, and derivatives of these; and alkyl 5,5-dihydroxyvalerates such as methyl 5,5-dihydroxyvalerate, methyl 5,5-dimethoxyvalerate, methyl 5,5-diethoxyvalerate, methyl 5,5-dipropoxyvalerate, ethyl 5,5-dihydroxyvalerate, ethyl 5,5-dimethoxyvalerate, ethyl 5,5-diethoxyvalerate and ethyl 5,5-dipropoxyvalerate, and derivatives of these.

In addition to the compound of the above formula (i), examples of the "other solvent" include ethers such as diethylene glycol dimethyl ether, diethylene glycol diethyl ether, benzyl ethyl ether and dihexyl ether; esters such as methyl pyruvate, ethyl pyruvate, ethyl acetate, butyl acetate, benzyl acetate, ethyl benzoate, diethyl oxalate, diethyl maleate, ethylene carbonate, propylene carbonate and γ-butyrolactone; ketones such as methyl ethyl ketone, cyclohexaneone, diisobutyl ketone, acetonyl acetone, isophorone, 2-heptanone. 3-heptanone and 4-heptanone; amides such as N-methylpyrrolidone, N,N-dimethylformamide and N,N-dimethylacetamide; alcohols such as 1-octanol, 1-nonanol and benzyl alcohol; monoethers of diols such as ethylene glycol monomethyl ether, ethylene glycol monoethyl ether, diethylene glycol monomethyl ether and diethylene glycol monoethyl ether; and ether esters of diols such as ethylene glycol monomethyl ether acetate, ethylene glycol monoethyl ether acetate, propylene glycol monomethyl ether acetate and propylene glycol monoethyl ether acetate.

The compositions of the present invention may further contain a variety of additives as required.

Examples of the additives include surfactants for improving the coatability and the developability of an irradiated portion of a formed and dried coating and for reducing the striation. Examples of the surfactants include polyoxyethylene lauryl ether, polyoxyethylene stearyl ether, polyoxyethylene oleyl ether, polyoxyethylene octyl phenol ether, polyoxyethylene nonyl phenol ether, polyethylene glycol dilaurate, polyethylene glycol distearate and commercially available products such as Eftop EF301(TM), EF303(TM) and EF352(TM) (supplied by Tohken Products Ltd.), Megafac F171 and F173(TM) (supplied by Dainippon Ink & Chemicals Inc. ), Fluorad(TM) FC430 and FC431 (supplied by Sumitomo 3M Co., Ltd) , Asahi Guard(TM) AG710 and Surflon(TM) S-382, SC101,SC102, SC103, SC104, SC105, and SC106 (supplied by Ashai Glass Co., Ltd), KP341(TM) (supplied by Shin -Etsu Chemical Co., Ltd.), and Polyflow(TM) No. 75 and No. 95 (supplied by Kyoeisha Oils and Fats Co., Ltd) Kyoeisha Oils and Fats Co., Ltd).

The amount of the surfactant per 100 parts by weight of the resin (A) is generally 2 parts by weight or less.

Examples of other additives include an azo-containing compound, a halation preventer composed of an amine-containing compound, an adhesion aid, a storage stabilizer and an antifoamer.

The compositions of the present invention can be prepared by dissolving necessary amounts of the above resin (A), the radiation-sensitive acid-forming agent and optionally, other additives to be added as required in the above solvent.

The compositions of the present invention are applied onto a substrate such as a silicone wafer, etc., in the above solution form and dried to form a resist coating. For applying the solution onto the substrate, for example, the solution of the composition of the present invention is prepared, filtered, and then applied onto the substrate by spin coating, curtain flow coating or roll coating.

The so-formed resist coating is partly irradiated with radiation to form a fine pattern. The radiation is not specially limited, and can be selected from ultraviolet light such as i-ray, far ultraviolet light from an excimer laser. X ray such as synchrotron radiation, or charged corpuscular beam such as electron beam, depending upon the kind of a used radiation-sensitive acid-forming agent. The irradiation conditions such as a radiation dose are properly determined depending upon the components and mixing ratio of the composition and kinds of various additives.

In the present invention, it is preferred to carry out heating after the irradiation with radiation for improving the apparent sensitivity, etc., of the resist. Although differing depending upon the components and mixing ratio of the composition, the heating temperature is generally 30 to 200°C, preferably 50 to 150°C.

The developer solution used for the development at a next step is selected from alkaline solutions containing sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, dimethylethanolamine, triethanolamine, tetramethylammonium hydroxide, tetraethylammonium hydroxide, pyrrole, piperidine, 1,8-diazabicyclo[5.4.0]-7-undecene or 1,5-diazabicyclo-[4.3.0]-5-nonene.

As a developer solution, there may be also used an alkaline aqueous solution prepared by adding a water-soluble organic solvent such as an alcohol, i.e., methanol or ethanol and a surfactant to the above developer solution.

The resist coating composition of the present invention is suitable as a resist coating composition which is excellent storage stability and is capable of giving a good pattern form. The resist coating composition of the present invention is suitable for use with any radiation including ultraviolet light such as i-ray, far ultraviolet light from an excimer laser, X-ray such as synchrotron radiation and charged corpuscular beam such as electron beam. Therefore, it can be advantageously used as a resist for producing semiconductor devices which are expected to become much finer.

The present invention will be detailed hereinafter by reference to Examples. However, the present invention shall not be limited by the Examples.

In Examples, various properties were measured as follows.

### Mw

Measured by a gel permeation chromatography using GPC columns (two G2000H_{XL,} columns, one G3000H_{XL} column and one G4000_{XL} coluan) supplied by Tosoh Corp and monodisperse polystyrene as a standard under the analysis conditions where the flow rate was 1.0 ml/minute, the elution solvent was tetrahydrofuran and the column temperature was 40°C.

### Sensitivity

The radiation dose at which a line and space pattern having a line and space breadth of 0.5 µm could be formed as designed was taken as sensitivity. The unit was mJ/cm²

### Amount of remaining coating

The resist coating thickness before and after the development was measured with Alpha-Step supplied by TENCOR, and the amount was calculated.

### Synthesis Example 1

30 Grams of polyhydroxyethylene was dissolved in tetrahydrofuran. and 10 g of t-butoxypottasium was added. While the mixture was stirred at 0°C, 60 g of di-t-butyldicarbonate was added dropwise, and the mixture was allowed to react for 4 hours. After the reaction finished, the reaction mixture was added dropwise to water to precipitate a resin, and the precipitated resin was dried in a vacuum dryer at 50°C overnight. The resin had Mw of 15,000, and the result of NMR measurement showed that the resin had a structure in which 29 % of hydrogen atoms of phenolic hydroxyl group were replaced with t-butoxycarbonyl group. This resin is referred to as "resin I" hereinafter.

### Synthesis Example 2

300 Grams of p-t-butoxystyrene, 30 g of styrene and 1.6 g of azobisisobutyronitrile were dissolved in 330 g of dioxane. The mixture was allowed to react under nitrogen atmosphere for 12 hours while the inside temperature was maintained at 70°C. After the reaction finished, unreacted monomers were removed by residimentation to obtain a poly(p-t-butoxystyrene/styrene) copolymer resin. Subsequently. the resin was hydrolyzed with an acid to give 180 g of poly(p-hydroxystyrene/styrene) copolymer resin having MW of 18,000. NMR showed that the copolymer ratio of p-hydroxystyrene to styrene was 85 to 15 (molar ratio). This resin is referred to as "resin II" hereinafter.

### Examples 1 - 6 and Comparative Examples 1 - 6

Components shown in Table 1 were dissolved in a solvent shown in Table 1. Then, foreign substances were removed from the mixture by microfiltration through a 0.2 m filter to obtain a resist coating composition.

The resist coating composition was spin-coated on a silicon wafer and baked at 100°C for 2 minutes, and the so-formed resist coating was exposed to radiation through a mask by means of a KrF excimer laser apparatus (MBK-400TL-N (TM)) supplied by Admont Science. Then, the resist coating was baked at 110°C for 2 minutes, developed with a solution of 2.38% of tetramethylammonium hydroxide in water at 23°C for 60 seconds and rinsed with water for 30 seconds to form a resist pattem. The above resist pattern formation was repeated with regard to a resist coating composition just after its preparation and after the storage of 30 days. The results are shown in Table 1.

The mixing ratio (part by weight) of the components and solvent in each Example was as follows.

### Comparative Examples 1 and 4:

Resin: 100. Acid-forming agent: 1.5. Solvent: 420.

Examples 2, 4, 6 and 22:- Resin 100, Acid-forming agent 1.5. Solvent: 420.

### Examples 1 - 6 and Comparative Examples 2- 3, 5 and 6:

Resin: 100. Acid-forming agent: 3. Solubility controller or Crosslinking agent: 35, solvent: 400.

In Table 1, numerals 1 and 5 in the column of "Acid-forming agent" and alphabet letters f to I in the column of "Crosslinking agent" show the following.

### (I) Acid-forming agent

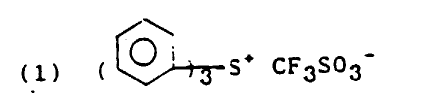

### Crosslinking agent

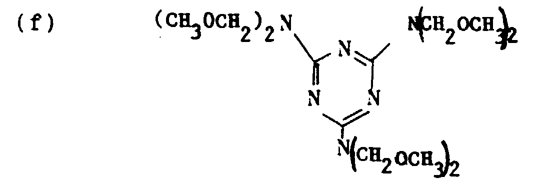

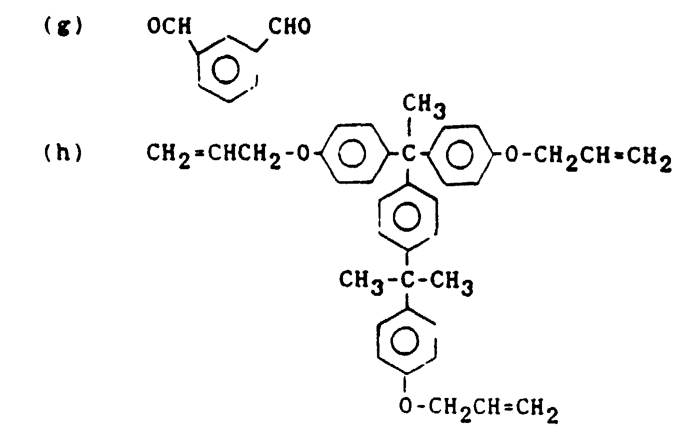

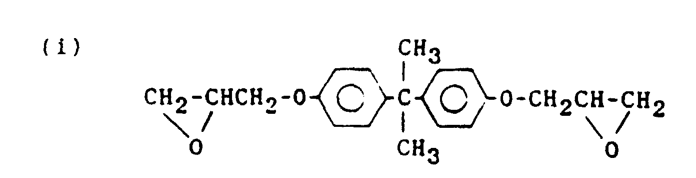

### (III) Solvent

The following are abbreviations of the compounds for a solvent.
- MMP:: Methyl 3-methoxypropionate
- EEP:: Ethyl 3-ethoxypropionate
- EL:: Ethyl 2-hydroxypropionate
- MEP:: Ethyl 2-methoxypropionate

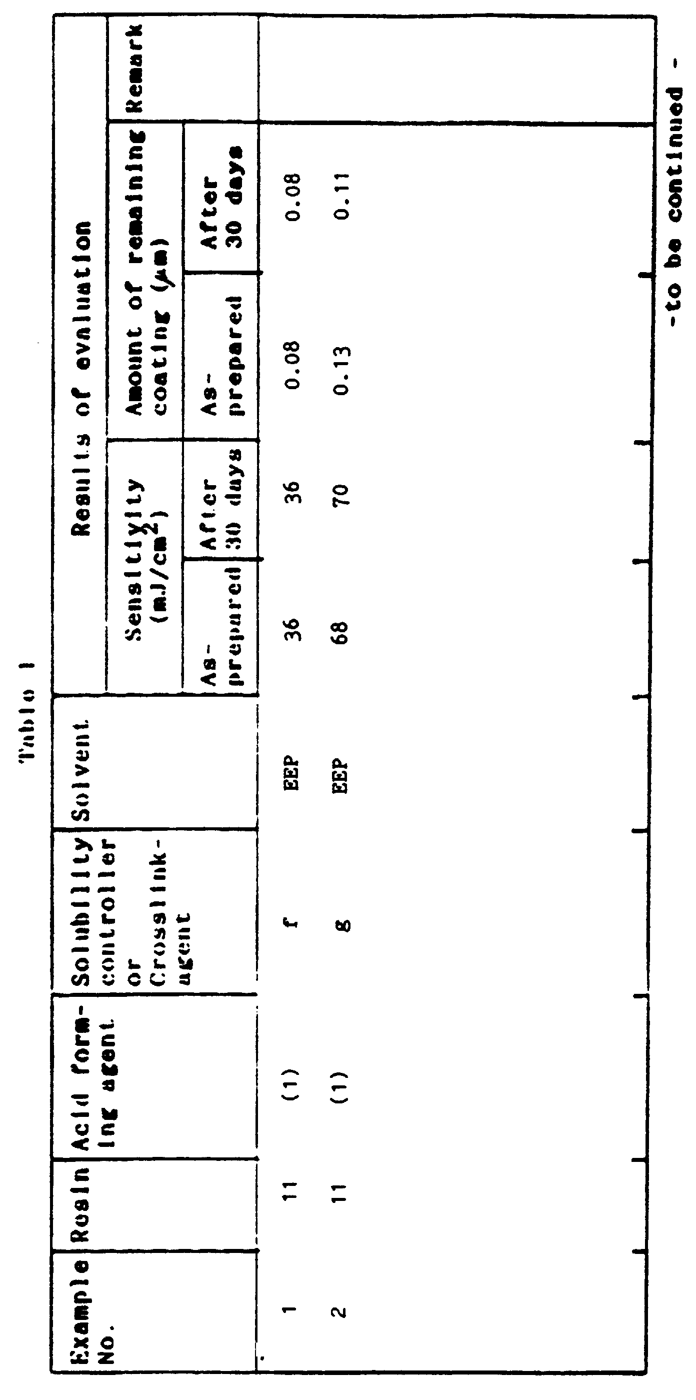

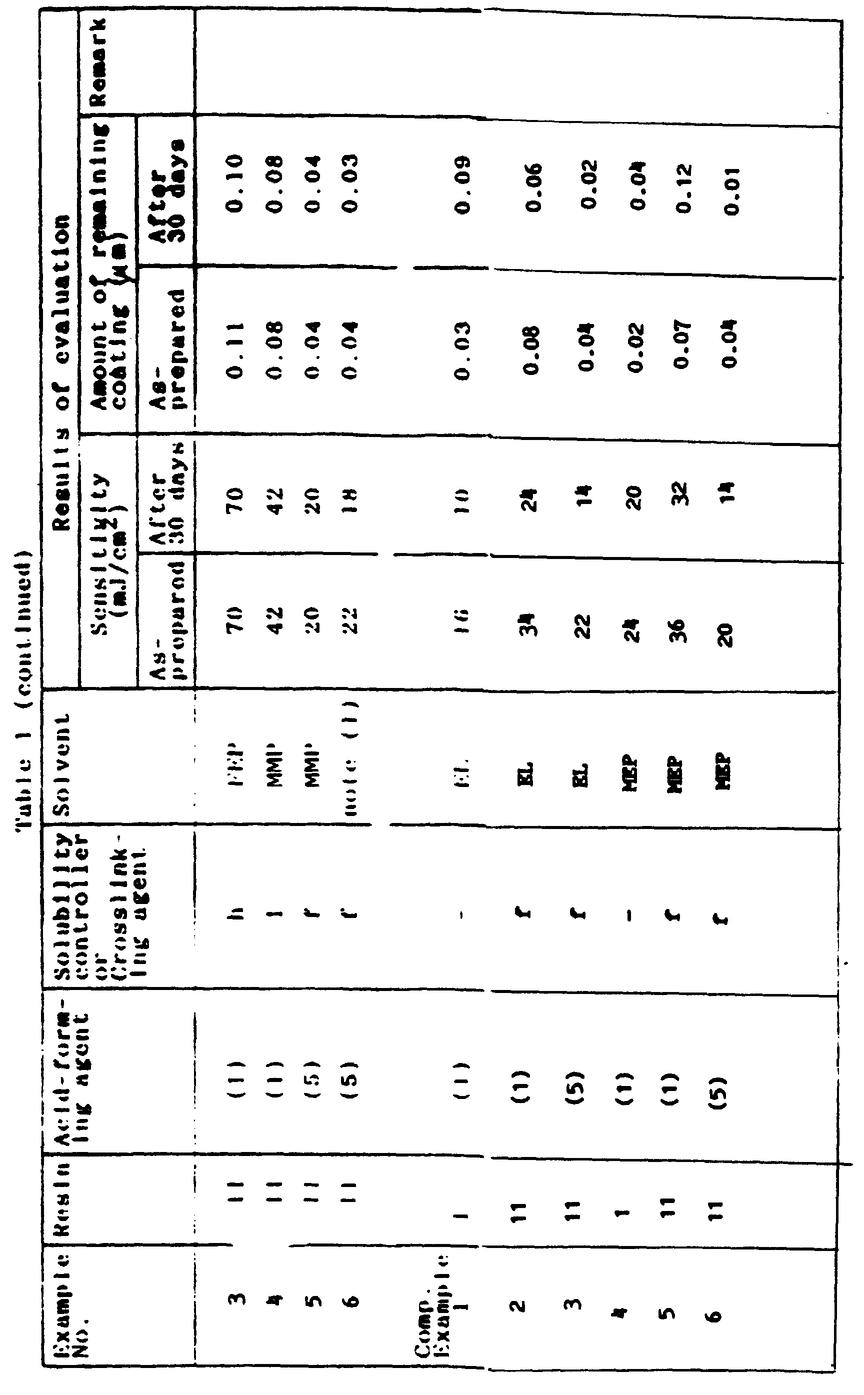

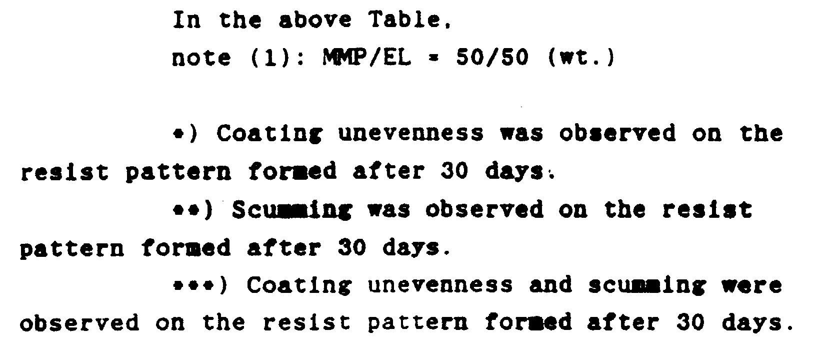

## Claims

1. A negative resist coating composition comprising:
(a) 100 parts by weight of an alkali-soluble resin,
(b) 1 to 70 parts by weight of at least one radiation-sensitive acid-forming agent selected from the group consisting of an onium salt compound, a halogen-containing compound, a sulfonate compound, a nitrobenzyl compound and a sulfone compound,
(c') 5 to 95 parts by weight of a compound which crosslinks the (a) alkali-soluble resin in the presence of an acid, and
(d) 20 to 3000 parts by weight of at least one solvent selected from methyl 3-methoxypropionate or ethyl 3-ethoxypropionate.

2. The negative resist coating composition of Claim 1, wherein the (c') compound is an aromatic compound having a group of the following formula,
-C-(R³⁷R³⁸)-OR³⁹
wherein each of R³⁷ and R³⁸ is independently hydrogen atom or an alkyl group having 1 to 4 carbon atoms and R³⁹ is hydrogen atom or an alkyl group having 1 to 5 carbon atoms, an aralkyl group having 7 to 20 carbon atoms, a group of -NR⁴⁰R⁴¹ in which each of R⁴⁰ and r⁴¹ is independently an alkyl group having 1 to 4 carbon atoms or a cyclo-ring which has 3 to 8 cyclic member atoms and may contain a hetero-atom, or a group of -COR⁴² in which R⁴² is an alkyl group having 1 to 4 carbon atoms or an aryl group having 6 to 14 carbon atoms,
an aromatic compound having a group of the following formula,
-CO-R⁴³
wherein R⁴³ is hydrogen atom or an alkyl group having 1 to 4 carbon atoms,
an aromatic compound having a group of the following formula,
-CR⁴⁴=CR⁴⁵R⁴⁶
wherein each of R⁴⁴, R⁴⁵ and R⁴⁶ is independently hydrogen atom or an alkyl group having 1 to 4 carbon atoms,
or an aromatic compound having a group of the following formula,
-C(R⁴⁷R⁴⁸)R⁴⁹
wherein each of R⁴⁷ and R⁴⁸ is independently hydrogen atom or an alkyl group having 1 to 4 carbon atoms, and R⁴⁹ is a three-membered ring which consists of either an oxygen atom or a divalent sulfur atom and of two carbon and hydrogen atoms and which may have a substituent having 1 to 3 carbon atoms.

## Patentansprüche

1. Negativ-Resist-Beschichtungszusammensetzung, umfassend:
(a) 100 Gewichtsteile alkalilösliches Harz;
(b) 1 bis 70 Gewichtsteile mindestens eines auf Strahlung ansprechenden Säurebildners, ausgewählt aus der Gruppe, bestehend aus einer Oniumsalz-Verbindung, einer Halogen enthaltenden Verbindung, einer Sulfonat-Verbindung, einer Nitrobenzyl-Verbindung und einer Sulfon-Verbindung;
(c') 5 bis 95 Gewichtsteile einer Verbindung, die das (a) alkalilösliche Harz in Gegenwart einer Säure vernetzt; sowie
(d) 20 bis 3000 Gewichtsteile mindestens eines Lösemittels, ausgewählt aus Methyl-3-methoxypropionat oder Ethyl-3-ethoxypropionat.

2. Negativ-Resist-Beschichtungszusammensetzung nach Anspruch 1, bei der die (c') Verbindung eine aromatische Verbindung ist mit einer Gruppe der folgenden Formel:
-C-(R³⁷R³⁸)-OR³⁹
worin jedes R³⁷ und R³⁸ unabhängig ein Wasserstoffatom oder eine Alkyl-Gruppe mit 1 bis 4 Kohlenstoffatomen ist und R³⁹ ein Wasserstoffatom oder eine Alkyl-Gruppe mit 1 bis 5 Kohlenstoffatomen; eine Aralkyl-Gruppe mit 7 bis 20 Kohlenstoffatomen; eine Gruppe von -NR⁴⁰R⁴¹, in der R⁴⁰ und R⁴¹ unabhängig eine Alkyl-Gruppe mit 1 bis 4 Kohlenstoffatomen sind oder ein Cyclo-Ring, der über 3 bis 8 Ringatome verfügt und ein Heteroatom enthalten kann; oder eine Gruppe von -COR⁴², in der R⁴² eine Alkyl-Gruppe mit 1 bis 4 Kohlenstoffatomen ist oder eine Aryl-Gruppe mit 6 bis 14 Kohlenstoffatomen;
eine aromatische Verbindung mit einer Gruppe der folgenden Formel:
-CO-R⁴³
worin R⁴³ ein Wasserstoffatom oder eine eine Alkyl-Gruppe mit 1 bis 4 Kohlenstoffatomen ist;
eine aromatische Verbindung mit einer Gruppe der folgenden Formel:
-CR⁴⁴ = CR⁴⁵R⁴⁶
worin jedes R⁴⁴, R⁴⁵ und R⁴⁶ unabhängig ein Wasserstoffatom oder eine Alkyl-Gruppe mit 1 bis 4 Kohlenstoffatomen ist;
oder eine aromatische Verbindung mit einer Gruppe der folgenden Formel:
-C(R⁴⁷R⁴⁸)R⁴⁹
worin jedes R⁴⁷ und R⁴⁸ unabhängig ein Wasserstoffatom oder eine Alkyl-Gruppe mit 1 bis 4 Kohlenstoffatomen ist, und R⁴⁹ ist ein dreigliedriger Ring, der entweder aus einem Sauerstoffatom oder einem zweiwertigen Schwefelatom sowie aus zwei Kohlenstoff- und Wasserstoffatomen besteht und der einen Substituenten mit 1 bis 3 Kohlenstoffatomen haben kann.

## Revendications

1. Composition de revêtement formant réserve négative comprenant:
(a) 100 parties en poids d'une résine soluble en milieu alcalin,
(b) de 1 à 70 parties en poids d'au moins un agent de formation d'acide sensible au rayonnement choisi dans le groupe constitué d'un composé de sel d'onium, d'un composé contenant un halogène, d'un composé de sulfonate, d'un composé de nitrobenzyle et d'un composé de sulfone,
(c') de 5 à 95 parties en poids d'un composé qui réticule la résine soluble en milieu alcalin (a) en présence d'un acide, et
(d) de 20 à 3000 parties en poids d'au moins un solvant choisi entre du méthyl-3-méthoxypropionate ou de l'éthyl-3-éthoxypropionate.

2. Composition de revêtement formant réserve négative suivant la revendication 1, dans laquelle le composé (c') est un composé aromatique possédant un groupe de la formule suivante:
-C-(R³⁷R³⁸)-OR³⁹
dans laquelle chacun des groupes R³⁷ et R³⁸ représente indépendamment un atome d'hydrogène ou un groupe alkyle avec 1 à 4 atomes de carbone et R³⁹ représente un atome d'hydrogène ou un groupe alkyle avec 1 à 5 atomes de carbone, un groupe aralkyle avec 7 à 20 atomes de carbone, un groupe de -NR⁴⁰R⁴¹ dans lequel chacun des groupes R⁴⁰ et R⁴¹ représente indépendamment un groupe alkyle avec 1 à 4 atomes de carbone ou un anneau cyclique qui possède de 3 à 8 atomes de membre cyclique et peut contenir un hétéroatome, ou un groupe de -COR⁴² dans lequel R⁴² représente un groupe alkyle avec 1 à 4 atomes de carbone ou un groupe aryle avec 6 à 14 atomes de carbone,
un composé aromatique possédant un groupe de la formule suivante:
-CO-R⁴³
dans laquelle R⁴³ représente un atome d'hydrogène ou un groupe alkyle avec 1 à 4 atomes de carbone,
un composé aromatique possédant un groupe de la formule suivante:
-CR⁴⁴=CR⁴⁵R⁴⁶
dans laquelle chacun des groupes R⁴⁴, R⁴⁵ et R⁴⁶ représente indépendamment un atome d'hydrogène ou un groupe alkyle avec 1 à 4 atomes de carbone,
ou un composé aromatique possédant un groupe de la formule suivante:
-C(R⁴⁷R⁴⁸)R⁴⁹
dans laquelle chacun des groupes R⁴⁷ et R⁴⁸ représente indépendamment un atome d'hydrogène ou un groupe alkyle avec 1 à 4 atomes de carbone et R⁴⁹ représente un anneau à trois membres qui est constitué soit d'un atome d'oxygène, soit d'un atome de soufre divalent, et de deux atomes de carbone et d'hydrogène et qui peut contenir un substituant avec 1 à 3 atomes de carbone.
